# EUROPEAN PATENT SPECIFICATION

(11) **EP 4 020 472 B1**
(45) Date of publication and mention of the grant of the patent: **03.04.2024**
(21) Application number: 21198388.7
(22) Date of filing: 22.09.2021
(51) Int. Cl.: G11C 5/02, G11C 5/04, G11C 5/06, H01L 25/18

(54) **IMPROVED MEMORY MODULE THAT CONSERVES MOTHERBOARD WIRING SPACE**
VERBESSERTES SPEICHERMODUL MIT ERHALTUNG VON VERDRAHTUNGSRAUM AUF DER HAUPTPLATINE
MODULE DE MÉMOIRE AMÉLIORÉ CONSERVANT L'ESPACE DE CÂBLAGE DE CARTE MÈRE

(30) Priority: 23.12.2020 US 202017132504
(43) Date of publication of application: 29.06.2022
(73) Proprietor: Intel Corporation, Santa Clara, CA 95054 (US)
(72) Inventor: LI, Xiang, Portland, OR 97229 (US); VERGIS, George, Portland, OR 97229 (US); GANGULY, Konika, Portland, OR 97229 (US)
(74) Representative: Rummler, Felix

(56) References cited:
- US-A1- 2006 034 061
- US-A1- 2008 038 961

## Description

### Field of the Invention

The field of invention pertains generally to the electronic arts, and, more specifically, to an improved memory module that conserves motherboard wiring space.

### Background

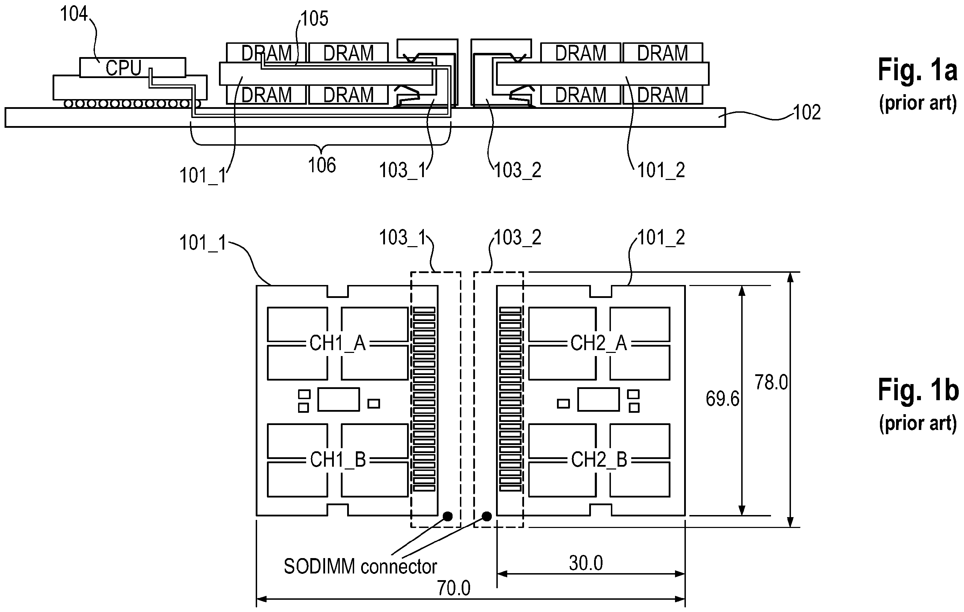

Figs. 1a and 1b show a pair of small outline dual-in memory modules 101_1, 101_2 (SODIMMs) arranged in a "butterfly" implementation (Fig. 1a shows a side view and Fig. 1b shows a top-down view). In the case of a butterfly operation, the SODIMMs 101_1, 101_2 are oriented such that their respective faces lie in parallel with the motherboard 102 that the SODIMMs 101_1, 101_2 are plugged into.

As can be seen in Figs. 1a and 1b, both SODIMMs 101_1, 101_2 have an edge with electrical inputs/outputs (I/Os) that physically and electrically mate with a corresponding connector 103_1, 103_2that is mounted to the motherboard 102. Each connector 103_1, 103_2 physically secures its SODIMM 101_1, 101_2 to the motherboard 102 as well as includes electrical wiring to transport signals between the SODIMM 101_1, 101_2 and the motherboard 102.

Typically, butterfly SODIMMs are placed near a high performance semiconductor chip 104, such as a processor, that uses the memory chips on the SODIMMs 101_1, 101_2 as a local or main memory.

In the particular prior art implementation of Figs. 1a and 1b, one Joint Electron Device Engineering Council (JEDEC) dual data rate (DDR) memory channel is routed to each SODIMM (e.g., a first DDR5 memory channel is routed to the first SODIMM 101_1 and a second DDR5 memory channel is routed to the second DIMM 101_2). The high performance semiconductor chip 104 therefore accesses the memory chips on the different SODIMMs 101_1, 101_2 by accessing different memory channels that emanate from the high performance semiconductor chip.

US 2008 038 961 A1 is disclosing a memory module having multiple connectors.

### Summary

The invention is as defined in the independent claim 1. Preferred embodiments are set out by the dependent claims.

### Figures

A better understanding of the present invention can be obtained from the following detailed description in conjunction with the following drawings, in which:
Figs. 1a and 1b depict a prior art SODIMM butterfly arrangement;
Figs. 2a and 2b depict an improved SODIMM;
Figs. 3a, 3b, 3c, 3d and 3e depict embodiments of an improved SODIMM;
Fig. 4 depicts a computer system;
Fig. 5 depicts a data center;
Fig. 6 depicts a rack.

### Detailed Description

A problem with the butterfly arrangement of Figs. 1a and 1b is that there is significant inefficiency with respect to the signal wiring between the high performance semiconductor chip 104 and the memory chips that are on the SODIMM 101_1 that is nearest the high performance semiconductor chip 104.

Here, as can be seen with highlighted signal trace 105, there is significant "double-back" in that the trace runs for an extended distance away from the high performance semiconductor chip 104 so that it can reach connector 103_1, only to double-back in the opposite direction in order to reach the high performance semiconductor chip 104.

As system designers are increasingly seeking ways to pack more and more function into smaller and smaller form factors, space for signal traces in the motherboard 102 is becoming more and more constrained. Here, the extended double-back run segment 106 of the highlighted trace 105 in Fig. 1 corresponds to inefficient use of motherboard space. If the segment 106 could be shortened, the freed-up space could be used for other signals and relieve the motherboard's 102 wiring space constraints.

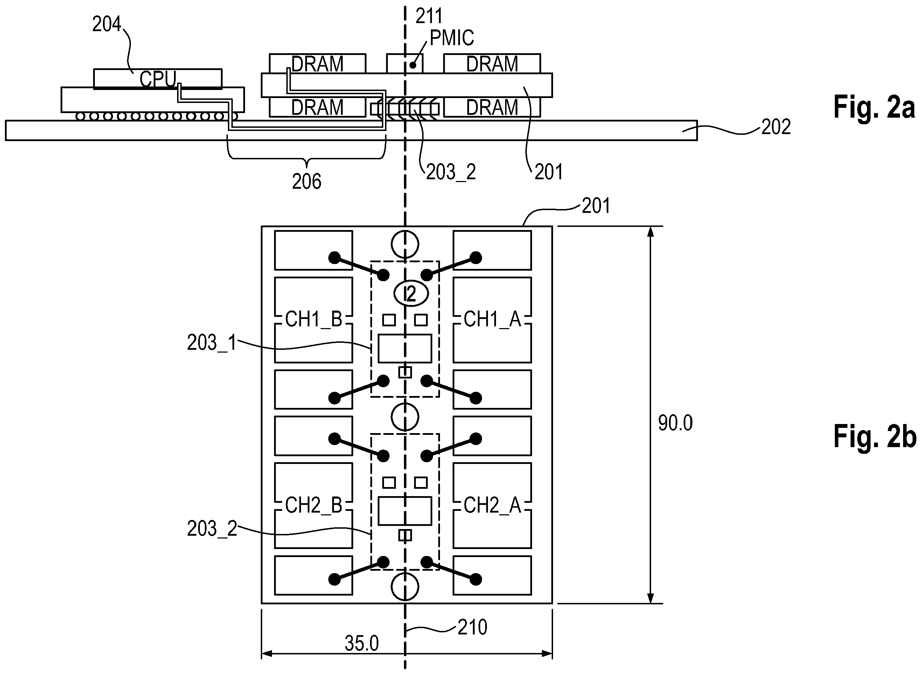

Figs. 2a and 2b show an improved approach that places the connector(s) 203 for an improved form factor DIMM 201 along a center axis 210 of the DIMM 201 rather than along the DIMM edge. Fig. 2a shows a side view and Fig. 2b shows a top down view.

With respect to the side view of Fig. 2a, the placement of the connector 203_2 along the center axis 210 of the improved form factor DIMM 201 greatly reduces the length of the double-backed trace segment 206. That is, rather than extend in a direction away from the high performance semiconductor chip 204 all the way to the far edge of the DIMM 201, instead, the signal trace only has to extend to the middle region of the DIMM 201. The length of the double-back segment 206 of Fig. 2a is therefore (approximately) half the length of the double-back segment 106 in the prior art solution of Fig. 1a.

Moreover, as observed in Fig. 2b, the memory chips that are coupled to different channels are placed "side-by-side" rather than, as observed in Fig. 1b, the memory chips of one SODIMM 101_1 being between the high performance semiconductor chip 104 and the memory chips of the other SODIMM 101_2.

With the side by side arrangement, the memory chips for both channels can be placed on the improved form factor DIMM 201. That is, the memory chips for a first JEDEC DDR memory channel "CH1" (e.g., a DDR5 memory channel) are placed in an upper portion of the DIMM 201 and the memory chips for a second JEDEC DDR memory channel "CH2" are placed in a lower portion of the DIMM 201 (the memory chips for both regions/channels have a right "A" portion and a left "B" portion).

Both memory channels have their own associated connector on the improved form factor DIMM 201. That is, connector 203_1 couples the memory chips in the upper region of the DIMM 201 to the first memory channel CH1, and, connector 203_2 couples the memory chips in the lower region of the DIMM 201 to the second memory channel CH2 (in various embodiments, the improved form factor DIMM 201 includes buffer chips that are coupled between the memory chips and the connectors).

Thus, the approach of Figs. 2a and 2b not only economizes the wiring space of the motherboard 202 but also economizes the hardware implementation as compared to the approach of Figs. 1a and 1b (one fewer DIMM printed circuit board is consumed).

In various embodiments there is one power management integrated circuit (PMIC) chip per channel or per DIMM. Thus, for the particular improved form factor DIMM 201 of Figs. 2a and 2b there can be one or two PMIC chips. Regardless, in various embodiments, the single or pair of PMIC chips 211 are placed along the center axis 210 of the improved form factor DIMM 201 on the top side of the DIMM (the connectors 203_1, 203_2 are located along the center axis 210 of the DIMM 201 on the bottom side of the DIMM 201).

In the embodiment of Figs. 2a and 2b there can be two ranks per memory channel (memory chips on the top side correspond to one rank while memory chips on the bottom side correspond to the second rank). Each rank is divided into an A half and a B half where the A half is on the side of the DIMM 201 that is farther from the high performance semiconductor chip 204 and the B half is on the side of the DIMM 201 that is closer to the high performance semiconductor chip 204.

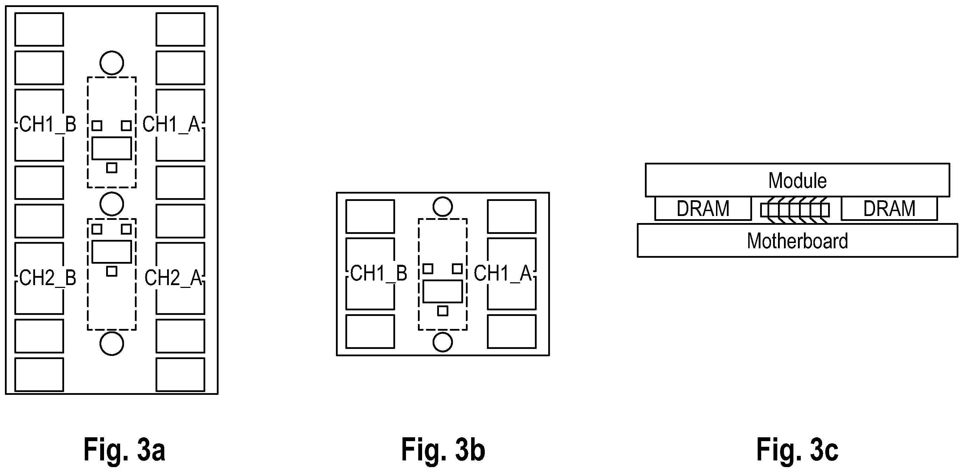

Figs. 3a through 3e show additional improved form factor DIMM versions that place the connector(s) along the DIMM's center axis. Fig. 3a shows a DIMM like the DIMM 201 of Figs. 2a and 2b but also has additional memory chips to store error correction code (ECC) information. The DIMM of Fig. 3a is therefore slightly longer than the DIMM of Figs. 2a and 2b.

Fig. 3b shows a single channel card that connects to only one channel and therefore has half the memory chips (and is (approximately) half the length) of the DIMM 201 of Figs. 2a and 2b.

Fig. 3c shows a single rank DIMM for extremely low profile implementations. Here, memory chips are not placed on the top face of the DIMM (which removes a rank per channel as compared to a DIMM that is populated on both faces with memory chips) to keep the vertical height of the DIMM small. The DIMM can be dual channel as in Figs. 2a,b, or, single channel as in Fig. 3b. Additionally, the DIMM of Fig. 3c can include or not include ECC memory chips.

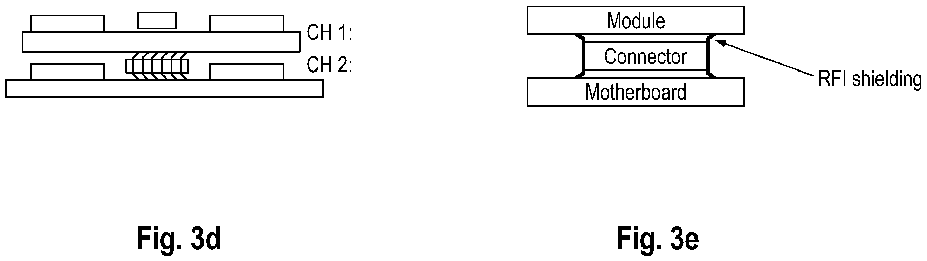

Fig. 3d shows another solution that integrates two ranks of memory chips per channel, but, one rank of memory chips is disposed on the top face of the DIMM and the other rank of memory chips is mounted directly on the motherboard. The solution of Fig. 3d can be used, e.g., for systems having a fixed amount of memory on the motherboard. The overall memory capacity can be expanded by adding one rank per channel per DIMM.

Connectors can be sources of emitted radiation which, e.g., introduce electrical noise into the system or elsewhere. Fig. 3e shows that any noise emitted by the connector of the improved form factor DIMM described above can be attenuated by shielding the connector with, e.g., grounded conductive material (e.g., metal foil) that encapsulates the connector between the top face of the motherboard and the bottom face of the DIMM.

Depending on system designer choice, one or more DIMMs can plug into a single channel. Thus, for example, another improved form factor DIMM may be placed next to the DIMM 201 of Fig. 2b where, the upper region of the other DIMM has memory chips that are coupled to the first channel and the lower region of the other DIMM has memory chips that are coupled to the second channel.

An improved form factor DIMM as described above can contain dynamic random access memory (DRAM) chips, non volatile byte addressable memory chips (e.g., three dimensional cross point memory where resistive storage cells are stacked above the chip substrate), such as Optane^{™} memory from Intel Corporation, or, a combination of DRAM and non volatile byte addressable memory chips.

It is pertinent to point out that the teachings above can potentially be applied to other modules besides DIMMs. For example, various other kinds of modules having one or more semiconductor chips that plug into a printed circuit board (motherboard) may have a connector that is disposed along a center axis of the module.

The chips that can be disposed on such modules can be any of a number of different high performance semiconductor chips (e.g., system-on-chip, accelerator chip (e.g., neural network processor), graphics processing unit (GPU), general purpose graphics processing unit (GPGPU), field programmable gate array (FPGA), application specific integrated circuit (ASIC)), an "X" processing unit ("XPU") where "X" can be any processor other than a general purpose processor (e.g., etc. G for graphics, D for data, I for infrastructure, etc.).

A PCB board having a module that makes use of the teachings herein can be integrated into a chassis having dimensions that are compatible with an industry standard rack (such as racks having 19" or 23" widthwise openings and having mounting holes for chassis having heights of specific height units (e.g., 1U, 2U, 3U where U = 1.75"). One example is the IEC 60297 Mechanical structures for electronic equipment - Dimensions of mechanical structures of the 482.6 mm (19 in) series. Generally, however, a chassis of any dimension is possible.

The electrical I/Os of the chip package to motherboard connections described above may be compatible with or used to transport signals associated with various data center computing and networking system interconnect technologies. Examples include, e.g., data and/or clocking signals associated with any of Infinity Fabric (e.g., as associated and/or implemented with Advanced Micro Devices (AMD^{™}) products) or derivatives thereof, specifications developed by the Cache Coherent Interconnect for Accelerators (CCIX) consortium or derivatives thereof, specifications developed by the GEN-Z consortium or derivatives thereof, specifications developed by the Coherent Accelerator Processor Interface (CAPI) or derivatives thereof, specifications developed by the Compute Express Link (CXL) consortium or derivatives thereof, specifications developed by the Hyper Transport consortium or derivative thereof, Ethernet, Infiniband, NVMe-oF, PCIe, etc.

A PCB board having a module that makes use of the teachings provided above, and/or the PCB board's associated electronic system, may contain the primary components of an entire computer system (e.g., CPU, main memory controller, main memory, peripheral controller and mass non-volatile storage), or, may contain the functionality of just some subset of an entire computer system (e.g., a chassis that contains primarily CPU processor power, a chassis that contains primarily main memory control and main memory, a chassis that contains primarily a storage controller and storage). The later can be particularly useful for disaggregated computing systems.

In the case of a dis-aggregated computer system, unlike a traditional computer in which the core components of a computing system (e.g., CPU processors, memory, storage, accelerators, etc.) are all housed within a common chassis and connected to a common motherboard, such components are instead integrated on separate pluggable cards or other pluggable components (e.g., a CPU card, a system memory card, a storage card, an accelerator card, etc.) that plug-into a larger exposed backplane or network instead of a same, confined motherboard. As such, for instance, CPU computer power can be added by adding CPU cards to the backplane or network, system memory can be added by adding memory cards to the backplane or network, etc. Such systems can exhibit even more high speed card to card connections that traditional computers. One or more dis-aggregated computers and/or traditional computers/servers can be identified as a Point of Delivery (PoD) for computing system function in, e.g., the larger configuration of an information technology (IT) implementation such as a data center.

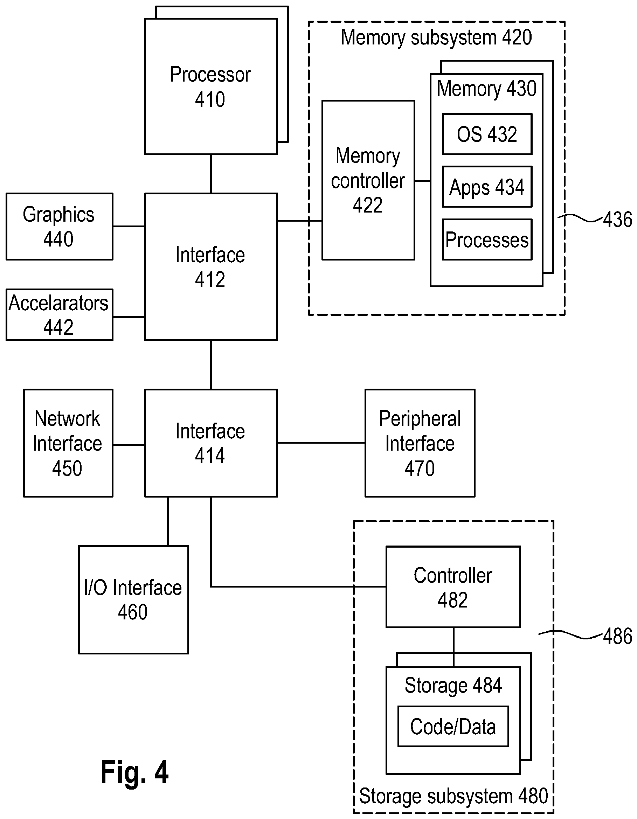

FIG. 4 depicts an example system. The system can use the teachings provided herein. System 400 includes processor 410, which provides processing, operation management, and execution of instructions for system 400. Processor 410 can include any type of microprocessor, central processing unit (CPU), graphics processing unit (GPU), processing core, or other processing hardware to provide processing for system 400, or a combination of processors. Processor 410 controls the overall operation of system 400, and can be or include, one or more programmable general-purpose or special-purpose microprocessors, digital signal processors (DSPs), programmable controllers, application specific integrated circuits (ASICs), programmable logic devices (PLDs), or the like, or a combination of such devices.

In one example, system 400 includes interface 412 coupled to processor 410, which can represent a higher speed interface or a high throughput interface for system components that needs higher bandwidth connections, such as memory subsystem 420 or graphics interface components 440, or accelerators 442. Interface 412 represents an interface circuit, which can be a standalone component or integrated onto a processor die. Where present, graphics interface 440 interfaces to graphics components for providing a visual display to a user of system 400. In one example, graphics interface 440 can drive a high definition (HD) display that provides an output to a user. High definition can refer to a display having a pixel density of approximately 100 PPI (pixels per inch) or greater and can include formats such as full HD (e.g., 1080p), retina displays, 4K (ultra-high definition or UHD), or others. In one example, the display can include a touchscreen display. In one example, graphics interface 440 generates a display based on data stored in memory 430 or based on operations executed by processor 410 or both. In one example, graphics interface 440 generates a display based on data stored in memory 430 or based on operations executed by processor 410 or both.

Accelerators 442 can be a fixed function offload engine that can be accessed or used by a processor 410. For example, an accelerator among accelerators 442 can provide compression (DC) capability, cryptography services such as public key encryption (PKE), cipher, hash/authentication capabilities, decryption, or other capabilities or services. In some embodiments, in addition or alternatively, an accelerator among accelerators 442 provides field select controller capabilities as described herein. In some cases, accelerators 442 can be integrated into a CPU socket (e.g., a connector to a motherboard or circuit board that includes a CPU and provides an electrical interface with the CPU). For example, accelerators 442 can include a single or multi-core processor, graphics processing unit, logical execution unit single or multi-level cache, functional units usable to independently execute programs or threads, application specific integrated circuits (ASICs), neural network processors (NNPs), "X" processing units (XPUs), programmable control logic, and programmable processing elements such as field programmable gate arrays (FPGAs). Accelerators 442 can provide multiple neural networks, processor cores, or graphics processing units can be made available for use by artificial intelligence (Al) or machine learning (ML) models. For example, the AI model can use or include any or a combination of: a reinforcement learning scheme, Q-learning scheme, deep-Q learning, or Asynchronous Advantage Actor-Critic (A3C), combinatorial neural network, recurrent combinatorial neural network, or other AI or ML model. Multiple neural networks, processor cores, or graphics processing units can be made available for use by AI or ML models.

Memory subsystem 420 represents the main memory of system 400 and provides storage for code to be executed by processor 410, or data values to be used in executing a routine. Memory subsystem 420 can include one or more memory devices 430 such as readonly memory (ROM), flash memory, volatile memory, or a combination of such devices. Memory 430 stores and hosts, among other things, operating system (OS) 432 to provide a software platform for execution of instructions in system 400. Additionally, applications 434 can execute on the software platform of OS 432 from memory 430. Applications 434 represent programs that have their own operational logic to perform execution of one or more functions. Processes 436 represent agents or routines that provide auxiliary functions to OS 432 or one or more applications 434 or a combination. OS 432, applications 434, and processes 436 provide software logic to provide functions for system 400. In one example, memory subsystem 420 includes memory controller 422, which is a memory controller to generate and issue commands to memory 430. It will be understood that memory controller 422 could be a physical part of processor 410 or a physical part of interface 412. For example, memory controller 422 can be an integrated memory controller, integrated onto a circuit with processor 410. In some examples, a system on chip (SOC or SoC) combines into one SoC package one or more of: processors, graphics, memory, memory controller, and Input/Output (I/O) control logic.

A volatile memory is memory whose state (and therefore the data stored in it) is indeterminate if power is interrupted to the device. Dynamic volatile memory requires refreshing the data stored in the device to maintain state. One example of dynamic volatile memory incudes DRAM (Dynamic Random Access Memory), or some variant such as Synchronous DRAM (SDRAM). A memory subsystem as described herein may be compatible with a number of memory technologies, such as DDR3 (Double Data Rate version 3, original release by JEDEC (Joint Electronic Device Engineering Council) on June 27, 2007). DDR4 (DDR version 4, initial specification published in September 2012 by JEDEC), DDR4E (DDR version 4), LPDDR3 (Low Power DDR versions, JESD209-3B, August 2013 by JEDEC), LPDDR4) LPDDR version 4, JESD209-4, originally published by JEDEC in August 2014), WIO2 (Wide Input/Output version 2, JESD229-2 originally published by JEDEC in August 2014, HBM (High Bandwidth Memory, JESD325, originally published by JEDEC in October 2013, LPDDRS (Low Power DDR 5, JESD209-5, originally published by JEDEC in February 2019), DDR5 (DDR version 5, JESD79-5, originally published by JEDEC in July 2020), HBM2 (HBM version 2), currently in discussion by JEDEC, or others or combinations of memory technologies, and technologies based on derivatives or extensions of such specifications. The JEDEC standards are available at www.jedec.org.

While not specifically illustrated, it will be understood that system 400 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect express (PCIe) bus, a HyperTransport or industry standard architecture (ISA) bus, a small computer system interface (SCSI) bus, Remote Direct Memory Access (RDMA), Internet Small Computer Systems Interface (iSCSI), NVM express (NVMe), Coherent Accelerator Interface (CXL), Coherent Accelerator Processor Interface (CAPI), a universal serial bus (USB), or an Institute of Electrical and Electronics Engineers (IEEE) standard 1394 bus.

In one example, system 400 includes interface 414, which can be coupled to interface 412. In one example, interface 414 represents an interface circuit, which can include standalone components and integrated circuitry. In one example, multiple user interface components or peripheral components, or both, couple to interface 414. Network interface 450 provides system 400 the ability to communicate with remote devices (e.g., servers or other computing devices) over one or more networks. Network interface 450 can include an Ethernet adapter, wireless interconnection components, cellular network interconnection components, USB (universal serial bus), or other wired or wireless standards-based or proprietary interfaces. Network interface 450 can transmit data to a remote device, which can include sending data stored in memory. Network interface 450 can receive data from a remote device, which can include storing received data into memory. Various embodiments can be used in connection with network interface 450, processor 410, and memory subsystem 420.

In one example, system 400 includes one or more input/output (I/O) interface(s) 460. I/O interface 460 can include one or more interface components through which a user interacts with system 400 (e.g., audio, alphanumeric, tactile/touch, or other interfacing). Peripheral interface 470 can include any hardware interface not specifically mentioned above. Peripherals refer generally to devices that connect dependently to system 400. A dependent connection is one where system 400 provides the software platform or hardware platform or both on which operation executes, and with which a user interacts.

In one example, system 400 includes storage subsystem 480 to store data in a nonvolatile manner. In one example, in certain system implementations, at least certain components of storage 480 can overlap with components of memory subsystem 420. Storage subsystem 480 includes storage device(s) 484, which can be or include any conventional medium for storing large amounts of data in a nonvolatile manner, such as one or more magnetic, solid state, or optical based disks, or a combination. Storage 484 holds code or instructions and data 486 in a persistent state (e.g., the value is retained despite interruption of power to system 400). Storage 484 can be generically considered to be a "memory," although memory 430 is typically the executing or operating memory to provide instructions to processor 410. Whereas storage 484 is nonvolatile, memory 430 can include volatile memory (e.g., the value or state of the data is indeterminate if power is interrupted to system 400). In one example, storage subsystem 480 includes controller 482 to interface with storage 484. In one example controller 482 is a physical part of interface 414 or processor 410 or can include circuits or logic in both processor 410 and interface 414.

A non-volatile memory (NVM) device is a memory whose state is determinate even if power is interrupted to the device. In one embodiment, the NVM device can comprise a block addressable memory device, such as NAND technologies, or more specifically, multithreshold level NAND flash memory (for example, Single-Level Cell ("SLC"), Multi-Level Cell ("MLC"), Quad-Level Cell ("QLC"), Tri-Level Cell ("TLC"), or some other NAND). A NVM device can also comprise a byte-addressable write-in-place three dimensional cross point memory device, or other byte addressable write-in-place NVM device (also referred to as persistent memory), such as single or multi-level Phase Change Memory (PCM) or phase change memory with a switch (PCMS), NVM devices that use chalcogenide phase change material (for example, chalcogenide glass), resistive memory including metal oxide base, oxygen vacancy base and Conductive Bridge Random Access Memory (CB-RAM), nanowire memory, ferroelectric random access memory (FeRAM, FRAM), magneto resistive random access memory (MRAM) that incorporates memristor technology, spin transfer torque (STT)-MRAM, a spintronic magnetic junction memory based device, a magnetic tunneling junction (MTJ) based device, a DW (Domain Wall) and SOT (Spin Orbit Transfer) based device, a thyristor based memory device, or a combination of any of the above, or other memory.

A power source (not depicted) provides power to the components of system 400. More specifically, power source typically interfaces to one or multiple power supplies in system 600 to provide power to the components of system 400. In one example, the power supply includes an AC to DC (alternating current to direct current) adapter to plug into a wall outlet. Such AC power can be renewable energy (e.g., solar power) power source. In one example, power source includes a DC power source, such as an external AC to DC converter. In one example, power source or power supply includes wireless charging hardware to charge via proximity to a charging field. In one example, power source can include an internal battery, alternating current supply, motion-based power supply, solar power supply, or fuel cell source.

In an example, system 400 can be implemented as a disaggregated computing system. For example, the system 600 can be implemented with interconnected compute sleds of processors, memories, storages, network interfaces, and other components. High speed interconnects can be used such as PCIe, Ethernet, or optical interconnects (or a combination thereof). For example, the sleds can be designed according to any specifications promulgated by the Open Compute Project (OCP) or other disaggregated computing effort, which strives to modularize main architectural computer components into rack-pluggable components (e.g., a rack pluggable processing component, a rack pluggable memory component, a rack pluggable storage component, a rack pluggable accelerator component, etc.).

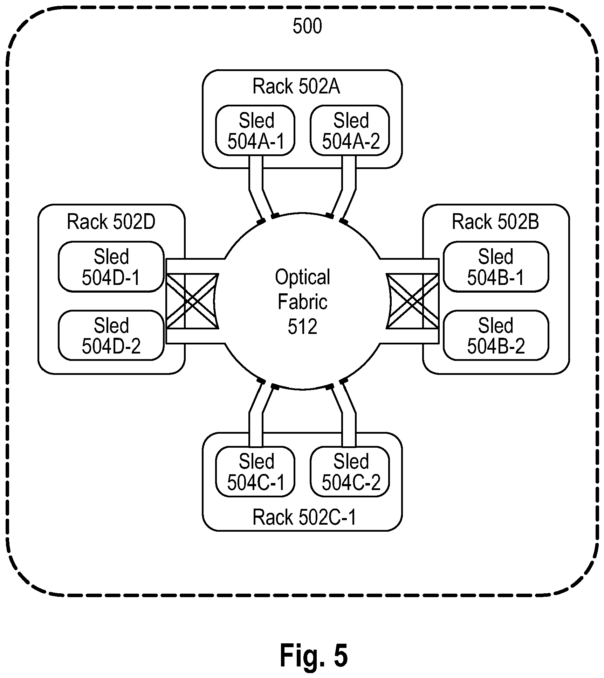

FIG. 5 depicts an example of a data center. Various embodiments can be used in or with the data center of FIG. 5. As shown in FIG. 5, data center 500 may include an optical fabric 512. Optical fabric 512 may generally include a combination of optical signaling media (such as optical cabling) and optical switching infrastructure via which any particular sled in data center 500 can send signals to (and receive signals from) the other sleds in data center 500. However, optical, wireless, and/or electrical signals can be transmitted using fabric 512. The signaling connectivity that optical fabric 512 provides to any given sled may include connectivity both to other sleds in a same rack and sleds in other racks. Data center 500 includes four racks 502A to 502D and racks 502A to 502D house respective pairs of sleds 504A-1 and 504A-2, 504B-1 and 504B-2, 504C-1 and 504C-2, and 504D-1 and 504D-2. Thus, in this example, data center 500 includes a total of eight sleds. Optical fabric 512 can provide sled signaling connectivity with one or more of the seven other sleds. For example, via optical fabric 512, sled 504A-1 in rack 502A may possess signaling connectivity with sled 504A-2 in rack 502A, as well as the six other sleds 504B-1, 504B-2, 504C-1, 504C-2, 504D-1, and 504D-2 that are distributed among the other racks 502B, 502C, and 502D of data center 500. The embodiments are not limited to this example. For example, fabric 512 can provide optical and/or electrical signaling.

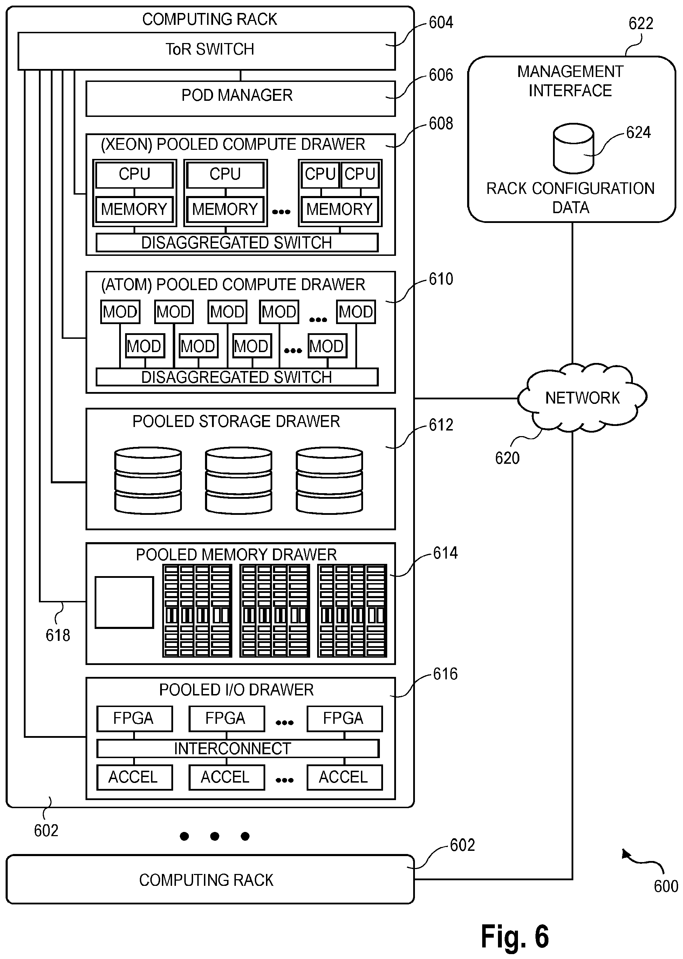

FIG. 6 depicts an environment 600 includes multiple computing racks 602, each including a Top of Rack (ToR) switch 604, a pod manager 606, and a plurality of pooled system drawers. Generally, the pooled system drawers may include pooled compute drawers and pooled storage drawers to, e.g., effect a disaggregated computing system. Optionally, the pooled system drawers may also include pooled memory drawers and pooled Input/Output (I/O) drawers. In the illustrated embodiment the pooled system drawers include an INTEL^{®} XEON^{®} pooled computer drawer 608, and INTEL^{®} ATOM^{™} pooled compute drawer 210, a pooled storage drawer 212, a pooled memory drawer 214, and an pooled I/O drawer 616. Each of the pooled system drawers is connected to ToR switch 604 via a high-speed link 618, such as a 40 Gigabit/second (Gb/s) or 100Gb/s Ethernet link or an 100+ Gb/s Silicon Photonics (SiPh) optical link. In one embodiment high-speed link 618 comprises an 800 Gb/s SiPh optical link.

Again, the drawers can be designed according to any specifications promulgated by the Open Compute Project (OCP) or other disaggregated computing effort, which strives to modularize main architectural computer components into rack-pluggable components (e.g., a rack pluggable processing component, a rack pluggable memory component, a rack pluggable storage component, a rack pluggable accelerator component, etc.).

Multiple of the computing racks 600 may be interconnected via their ToR switches 604 (e.g., to a pod-level switch or data center switch), as illustrated by connections to a network 620. In some embodiments, groups of computing racks 602 are managed as separate pods via pod manager(s) 606. In one embodiment, a single pod manager is used to manage all of the racks in the pod. Alternatively, distributed pod managers may be used for pod management operations.

Multiple rack environment 600 further includes a management interface 622 that is used to manage various aspects of the RSD environment. This includes managing rack configuration, with corresponding parameters stored as rack configuration data 624.

Embodiments herein may be implemented in various types of computing, smart phones, tablets, personal computers, and networking equipment, such as switches, routers, racks, and blade servers such as those employed in a data center and/or server farm environment. The servers used in data centers and server farms comprise arrayed server configurations such as rack-based servers or blade servers. These servers are interconnected in communication via various network provisions, such as partitioning sets of servers into Local Area Networks (LANs) with appropriate switching and routing facilities between the LANs to form a private Intranet. For example, cloud hosting facilities may typically employ large data centers with a multitude of servers. A blade comprises a separate computing platform that is configured to perform server-type functions, that is, a "server on a card." Accordingly, each blade includes components common to conventional servers, including a main printed circuit board (main board) providing internal wiring (e.g., buses) for coupling appropriate integrated circuits (ICs) and other components mounted to the board.

Various examples may be implemented using hardware elements, software elements, or a combination of both. In some examples, hardware elements may include devices, components, processors, microprocessors, circuits, circuit elements (e.g., transistors, resistors, capacitors, inductors, and so forth), integrated circuits, ASICs, PLDs, DSPs, FPGAs, memory units, logic gates, registers, semiconductor device, chips, microchips, chip sets, and so forth. In some examples, software elements may include software components, programs, applications, computer programs, application programs, system programs, machine programs, operating system software, middleware, firmware, software modules, routines, subroutines, functions, methods, procedures, software interfaces, APIs, instruction sets, computing code, computer code, code segments, computer code segments, words, values, symbols, or any combination thereof. Determining whether an example is implemented using hardware elements and/or software elements may vary in accordance with any number of factors, such as desired computational rate, power levels, heat tolerances, processing cycle budget, input data rates, output data rates, memory resources, data bus speeds and other design or performance constraints, as desired for a given implementation. It is noted that hardware, firmware and/or software elements may be collectively or individually referred to herein as "module," "logic," "circuit," or "circuitry."

Some examples may be implemented using or as an article of manufacture or at least one computer-readable medium. A computer-readable medium may include a non-transitory storage medium to store logic. In some examples, the non-transitory storage medium may include one or more types of computer-readable storage media capable of storing electronic data, including volatile memory or non-volatile memory, removable or nonremovable memory, erasable or non-erasable memory, writeable or re-writeable memory, and so forth. In some examples, the logic may include various software elements, such as software components, programs, applications, computer programs, application programs, system programs, machine programs, operating system software, middleware, firmware, software modules, routines, subroutines, functions, methods, procedures, software interfaces, API, instruction sets, computing code, computer code, code segments, computer code segments, words, values, symbols, or any combination thereof.

According to some examples, a computer-readable medium may include a non-transitory storage medium to store or maintain instructions that when executed by a machine, computing device or system, cause the machine, computing device or system to perform methods and/or operations in accordance with the described examples. The instructions may include any suitable type of code, such as source code, compiled code, interpreted code, executable code, static code, dynamic code, and the like. The instructions may be implemented according to a predefined computer language, manner or syntax, for instructing a machine, computing device or system to perform a certain function. The instructions may be implemented using any suitable high-level, low-level, object-oriented, visual, compiled and/or interpreted programming language.

One or more aspects of at least one example may be implemented by representative instructions stored on at least one machine-readable medium which represents various logic within the processor, which when read by a machine, computing device or system causes the machine, computing device or system to fabricate logic to perform the techniques described herein. Such representations, known as "IP cores" may be stored on a tangible, machine readable medium and supplied to various customers or manufacturing facilities to load into the fabrication machines that actually make the logic or processor

Some examples may be described using the expression "coupled" and "connected" along with their derivatives. These terms are not necessarily intended as synonyms for each other. For example, descriptions using the terms "connected" and/or "coupled" may indicate that two or more elements are in direct physical or electrical contact with each other. The term "coupled," however, may also mean that two or more elements are not in direct contact with each other, but yet still co-operate or interact with each other.

The terms "first," "second," and the like, herein do not denote any order, quantity, or importance, but rather are used to distinguish one element from another. The terms "a" and "an" herein do not denote a limitation of quantity, but rather denote the presence of at least one of the referenced items. The term "asserted" used herein with reference to a signal denote a state of the signal, in which the signal is active, and which can be achieved by applying any logic level either logic 0 or logic 1 to the signal. The terms "follow" or "after" can refer to immediately following or following after some other event or events. Other sequences of steps may also be performed according to alternative embodiments. Furthermore, additional steps may be added or removed depending on the particular applications. Any combination of changes can be used and one of ordinary skill in the art with the benefit of this disclosure would understand the many variations, modifications, and alternative embodiments thereof.

Disjunctive language such as the phrase "at least one of X, Y, or Z," unless specifically stated otherwise, is otherwise understood within the context as used in general to present that an item, term, etc., may be either X, Y, or Z, or any combination thereof (e.g., X, Y, and/or Z). Thus, such disjunctive language is not generally intended to, and should not, imply that certain embodiments require at least one of X, at least one of Y, or at least one of Z to each be present. Additionally, conjunctive language such as the phrase "at least one of X, Y, and Z," unless specifically stated otherwise, should also be understood to mean X, Y, Z, or any combination thereof, including "X, Y, and/or Z."

An apparatus has been described. The apparatus includes a memory module having a connector along a center axis of the memory module. The memory module further includes a first set of memory chips disposed in a first region of the memory module that resides between an edge of the memory module and a side of the connector, and, a second set of memory chips disposed in a second region of the memory module that resides between an opposite edge of the memory module and an opposite side of the connector.

In various embodiments the memory module is a dual in-line memory module (DIMM). In various embodiments the memory module is a small outline dual-in line memory module (SODIMM). In various embodiments the first set of memory chips are to be coupled to a memory channel. In various embodiments the second set of memory chips are to be coupled to the memory channel. In various embodiments a second memory channel is to be coupled to a rank of memory chips on the memory module. In various embodiments the first set of memory chips are part of a rank that stores ECC information. In various embodiments the memory module has additional memory chips on a face of the memory module, and, the first and second sets of memory chips are on an opposite face of the memory module.

A computing system has been described. The computing system includes a motherboard having a first connector. The memory module includes a second connector along a center axis of the memory module. The first connector is connected to the second connector. The memory module further includes a first set of memory chips disposed in a first region of the memory module that resides between an edge of the memory module and a side of the connector, and, a second set of memory chips disposed in a second region of the memory module that resides between an opposite edge of the memory module and an opposite side of the connector.

An apparatus is described. The apparatus includes a module to plug-into a printed circuit board. The module includes a connector along a center axis of the module. The module further includes a first semiconductor chip disposed in a first region of the module that resides between an edge of the module and a side of the connector, and, a second semiconductor chip disposed in a second region of the module that resides between an opposite edge of the module and an opposite side of the connector.

## Claims

1. An apparatus, comprising:
a memory module (201) comprising connectors (203) along a center axis of the memory module (201), the memory module (201) further comprising a first set of memory chips disposed in a first region of the memory module (201) that resides between an edge of the memory module (201) and a side of the connectors (203), and, a second set of memory chips disposed in a second region of the memory module (201) that resides between an opposite edge of the memory module (201) and an opposite side of the connectors (203), wherein the connectors (203) comprises a first connector (203_1) and a second connector (203), and the first connector (203_1) couples memory chips of the first and second sets of memory chips that are in an upper region of the memory module (201) to a first memory channel (CH1), and the second connector (203_2) couples memory chips of the first and second sets of memory chips that are in a lower region of the memory module (201) to a second memory channel (CH2).

2. The apparatus of claim 1 wherein the memory module (201) is a dual in-line memory module, DIMM.

3. The apparatus of claim 1 wherein the second memory channel is to be coupled to a rank of memory chips on the memory module (201).

4. The apparatus of claim 1 wherein the first set of memory chips are part of a rank that stores ECC information.

5. The apparatus of claim 1 wherein the memory module (201) comprises additional memory chips on a face of the memory module (201), the first set of memory chips and the second set of memory chips on an opposite face of the memory module (201).

6. A computing system comprising the subject matter of any of claims 1 through 5.

## Patentansprüche

1. Vorrichtung, die umfasst:
ein Speichermodul (201), das Anschlüsse (203) entlang einer Mittelachse des Speichermoduls (201) umfasst, wobei das Speichermodul (201) ferner einen ersten Satz von Speicherchips umfasst, die in einer ersten Region des Speichermoduls (201) angeordnet sind, die sich zwischen einer Flanke des Speichermoduls (201) und einer Seite der Anschlüsse (203) befindet, und einen zweiten Satz von Speicherchips, die in einer zweiten Region des Speichermoduls (201) angeordnet sind, die sich zwischen einer gegenüberliegenden Flanke des Speichermoduls (201) und einer gegenüberliegenden Seite der Anschlüsse (203) befindet, wobei die Anschlüsse (203) einen ersten Anschluss (203_1) und einen zweiten Anschluss (203) umfassen und der erste Anschluss (203_1) Speicherchips der ersten und zweiten Sätze von Speicherchips, die sich in einer oberen Region des Speichermoduls (201) befinden, mit einem ersten Speicherkanal (CH1) koppelt, und der zweite Anschluss (203_2) Speicherchips der ersten und zweiten Sätze von Speicherchips, die sich in einer unteren Region des Speichermoduls (201) befinden, mit einem zweiten Speicherkanal (CH2) koppelt.

2. Vorrichtung nach Anspruch 1, wobei das Speichermodul (201) ein Dual-In-Line-Speichermodul, DIMM, ist.

3. Vorrichtung nach Anspruch 1, wobei der zweite Speicherkanal mit einem Rank von Speicherchips auf dem Speichermodul (201) zu koppeln ist.

4. Vorrichtung nach Anspruch 1, wobei der erste Satz von Speicherchips Teil eines Ranks ist, der ECC-Informationen speichert.

5. Vorrichtung nach Anspruch 1, wobei das Speichermodul (201) zusätzliche Speicherchips auf einer Fläche des Speichermoduls (201) umfasst, wobei sich der erste Satz von Speicherchips und der zweite Satz von Speicherchips auf einer gegenüberliegenden Fläche des Speichermoduls (201) befinden.

6. Rechensystem, das den Gegenstand nach einem der Ansprüche 1 bis 5 umfasst.

## Revendications

1. Appareil, comprenant :
un module de mémoire (201) comprenant des connecteurs (203) le long d'un axe central du module de mémoire (201), le module de mémoire (201) comprenant en outre un premier ensemble de puces mémoire disposé dans une première région du module de mémoire (201) qui se trouve entre un bord du module de mémoire (201) et un côté des connecteurs (203), et un deuxième ensemble de puces mémoire disposé dans une deuxième région du module de mémoire (201) qui se trouve entre un bord opposé du module de mémoire (201) et un bord opposé des connecteurs (203), les connecteurs (203) comprenant un premier connecteur (203_1) et une deuxième connecteur (203), et le premier connecteur (203_1) couplant les puces mémoire des premier et deuxième ensembles de puces mémoire qui se trouvent dans une région supérieure du module de mémoire (201) à un premier canal de mémoire (CH1), et le deuxième connecteur (203_2) couplant les puces mémoire des premier et deuxième ensembles de puces mémoire qui se trouvent dans une région inférieure du module de mémoire (201) à un deuxième canal de mémoire (CH2).

2. Appareil selon la revendication 1, dans lequel le module de mémoire (201) est un module de mémoire à double rangée de connexions, DIMM.

3. Appareil selon la revendication 1, dans lequel le deuxième canal de mémoire est destiné à être couplé à une rangée de puces mémoire sur le module de mémoire (201).

4. Appareil selon la revendication 1, dans lequel le premier ensemble de puces mémoire fait partie d'une rangée qui stocke des informations ECC.

5. Appareil selon la revendication 1, dans lequel le module de mémoire (201) comprend des puces mémoire additionnelles sur une face du module de mémoire (201), le premier ensemble de puces mémoire et le deuxième ensemble de puces mémoire étant sur des faces opposées du module de mémoire (201).

6. Système informatique, comprenant l'objet de l'une quelconque des revendications 1 à 5.
